# EUROPEAN PATENT APPLICATION

(11) **EP 4 498 430 A1**
(43) Date of publication of application: **29.01.2025**
(21) Application number: 24165201.5
(22) Date of filing: 21.03.2024
(51) Int. Cl.: H01L 25/065, H01L 23/00, H01L 25/18

(54) **SEMICONDUCTOR DEVICE WITH ELECTRICAL VIAS**

(30) Priority: 28.07.2023 KR 20230098680
(71) Applicant: Samsung Electronics Co., Ltd., Suwon-si, Gyeonggi-do 16677 (KR)
(72) Inventor: SHIM, Kyuha, 16677 Suwon-si, Gyeonggi-do (KR); OH, Chisung, 16677 Suwon-si, Gyeonggi-do (KR); SHIN, Useung, 16677 Suwon-si, Gyeonggi-do (KR)
(74) Representative: Kuhnen & Wacker Patent- und Rechtsanwaltsbüro PartG mbB

(57) **Abstract**

According to some implementations, provided is a semiconductor device (1000A) including: a first semiconductor chip (C1) including first through-vias (130), and first front pads (104) electrically connected to the first through-vias (130); and a second semiconductor chip (C2) disposed below the first semiconductor chip (C1), and including a substrate (210), a circuit layer (220) disposed below the substrate (210), second front pads (204) below the circuit layer (220), rear pads disposed on the substrate (210) and electrically connected to the corresponding first front pads (104), second through-vias (230) penetrating through the substrate (210) and electrically connected to the second front pads (204), and a rear redistribution layer (140) electrically connecting the second through-vias (230) and the rear pads, wherein at least one of the rear pads is spaced apart from a corresponding one of the second through-vias (230) in a horizontal direction, and overlaps a corresponding one of the first through-vias (130) in a vertical direction.

## Description

### TECHNICAL FIELD

The present disclosure relates to semiconductor devices having electrical vias.

### BACKGROUND

With recent miniaturization and the implementation of high performance in electronic devices, three-dimensional semiconductor devices having a plurality of semiconductor chips stacked vertically have been developed using through-silicon vias (TSV). When constructing three-dimensional semiconductor devices by stacking heterogeneous chips, there can be design restrictions on vertically aligning a TSV region of each heterogeneous chip.

### SUMMARY

Some aspects of the present disclosure provide a semiconductor device having improved design freedom for a TSV region.

According to an aspect of the present disclosure, provided is a semiconductor device including: a first semiconductor chip including first through-vias, and first front pads electrically connected to the first through-vias; and a second semiconductor chip disposed below the first semiconductor chip, and including a substrate, a circuit layer disposed below the substrate, second front pads below the circuit layer, rear pads disposed on the substrate and electrically connected to the corresponding first front pads, second through-vias penetrating through the substrate and electrically connected to the second front pads, and a rear redistribution layer for electrically connecting the second through-vias and the rear pads, wherein at least one of the rear pads is spaced apart from a corresponding one of the second through-vias in a horizontal direction, and overlaps a corresponding one of the first through-vias in a vertical direction (is at least partially aligned in the vertical direction).

Furthermore, according to another aspect of the present disclosure, provided is a semiconductor device including: a first semiconductor chip including first through-vias arranged in a first TSV region, and first front pads electrically connected to the first through-vias; and a second semiconductor chip disposed below the first semiconductor chip, and including second through-vias arranged in a second TSV region, rear pads electrically connected to the front pads, and a rear redistribution layer for electrically connecting the second through-vias and the rear pads, wherein at least a portion of the first TSV region is offset from the second TSV region in a horizontal direction.

Furthermore, according to another aspect of the present disclosure, provided is a semiconductor device including: one or more semiconductor chips including first power vias; and a base chip disposed below the one or more semiconductor chips, and including second power vias, and a rear redistribution layer for electrically connecting the second power vias to the first power vias, wherein the first power vias include first sub-vias vertically overlapping the second power vias, and second sub-vias spaced apart from the second power vias in a horizontal direction.

Furthermore, according to another aspect of the present disclosure, provided is a semiconductor device including: at least one semiconductor chip including first through-vias; a base chip disposed below at least one semiconductor chip and including second through-vias; and a plurality of bumps disposed between the base chip and the at least one semiconductor chip, and configured to electrically connect the first through-vias and the second through-vias, wherein the first through-vias include first sub-vias arranged in a first sub-TSV region, and second sub-vias arranged in a second sub-TSV region, and a separation distance between the first sub-TSV region and the second sub-TSV region is greater than a gap between the first sub-vias adjacent to each other and a gap between the second sub-vias adjacent to each other.

Furthermore, according to another aspect of the present disclosure, provided is a semiconductor device including: a substrate; first and second power supply vias penetrating through the substrate; and a first power supply region in which the first power supply vias are arranged, and a second power supply region in which the second power supply vias are arranged, wherein a separation distance between the first power supply region and the second power supply region is greater than a gap between the first power supply vias adjacent to each other and a gap between the second power supply vias adjacent to each other.

According to some implementations of the present disclosure, a rear redistribution structure for redistributing TSV may be introduced, thereby providing a semiconductor device having improved design freedom for a TSV region.

Advantages and effects of the present application are not limited to the foregoing content and may be more easily understood in the process of describing examples of implementations of the present disclosure, as set forth below.

### BRIEF DESCRIPTION OF DRAWINGS

The above and other aspects, features, and advantages of the present disclosure will be more clearly understood from the following detailed description, taken in conjunction with the accompanying drawings.
FIG. 1A is a cross-sectional view of a semiconductor device according to some implementations of the present disclosure.
FIG. 1B is a partial enlarged view of region 'A' of FIG. 1A.
FIG. 1C is a perspective view illustrating a connection relationship between some semiconductor chips of FIG. 1A.
FIGS. 2A to 2D are plan views of examples of a TSV region.
FIG. 3A is a cross-sectional view of a semiconductor device according to some implementations of the present disclosure.
FIG. 3B is a partial enlarged view of region 'B' of FIG. 3A.
FIG. 4A is a cross-sectional view of a semiconductor device according to some implementations of the present disclosure.
FIG. 4B is a partial enlarged view of region 'C' of FIG. 4A.
FIG. 5A is a cross-sectional view of a semiconductor device according to some implementations of the present disclosure.
FIG. 5B is a partial enlarged view of region 'D' of FIG. 5A.
FIG. 6A is a cross-sectional view of a semiconductor device according to some implementations of the present disclosure.
FIG. 6B is a perspective view illustrating a connection relationship between some semiconductor chips of FIG. 6A.
FIG. 7 is a cross-sectional view of a semiconductor device according to some implementations of the present disclosure.
FIG. 8A is a cross-sectional view of a semiconductor device according to some implementations of the present disclosure.
FIG. 8B is a partial enlarged view of region 'G' of FIG. 8A.
FIG. 9A is a plan view of an example of a semiconductor package in which a semiconductor device according to some implementations of the present disclosure is mounted.
FIG. 9B is a cross-sectional view taken along line I-I' of FIG. 9A.

### DETAILED DESCRIPTION

Hereinafter, implementations of the present disclosure will be described with reference to the accompanying drawings. Unless otherwise specified, in the present specification, it may be understood that the expressions such as "on," "above," "upper," "below", "beneath," "lower," and "side," relate to orientations based on the drawings, and may actually vary depending on the direction in which the components are disposed.

In order to distinguish various elements, steps and directions from each other, ordinal numbers such as "first," "second," "third," etc. may be used as labels such as specific elements, steps, and directions, terms not described using "first," "second," etc. in the specification may still be referred to as "first" or "second" in the claim. In addition, terms referred to as specific ordinal numbers (e.g., "first" in certain claims) may be described as different ordinal numbers (e.g., "second" in specifications or other claims) elsewhere.

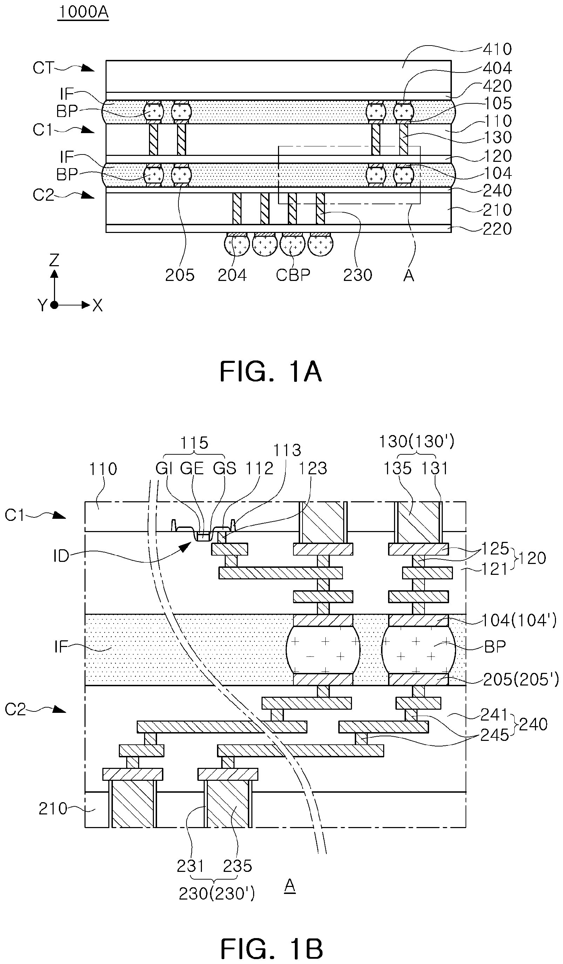

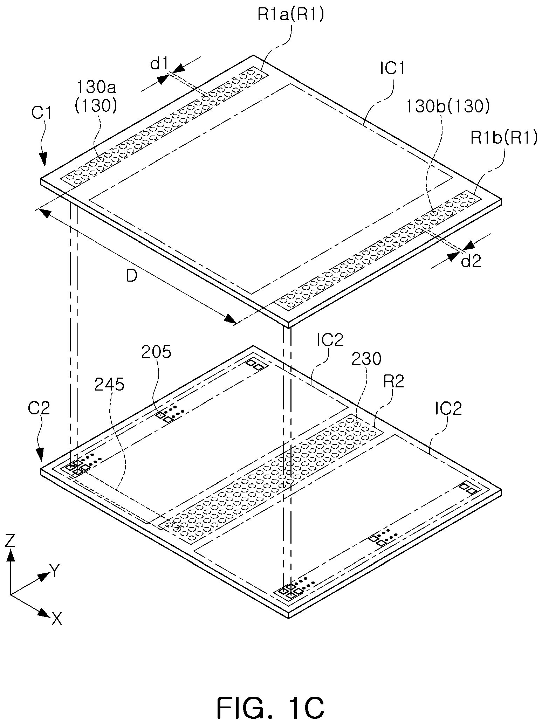

FIG. 1A is a cross-sectional view of a semiconductor device 1000A according to some implementations of the present disclosure, FIG. 1B is a partial enlarged view of region 'A' of FIG. 1A, and FIG. 1C is a perspective view illustrating a connection relationship between some semiconductor chips of FIG. 1A.

Referring to FIGS. 1A, 1B, and 1C, the semiconductor device 1000A of some implementations may include a first semiconductor chip C1 and a second semiconductor chip C2 (hereinafter referred to as a `base chip'). According to some implementations of the present disclosure, the first semiconductor chip C1 may be sequentially stacked on the second semiconductor chip C2, or may be provided in the form of a plurality of first semiconductor chips arranged in parallel. The first semiconductor chip C1 and the second semiconductor chip C2 are illustrated to have substantially the same size (width and area), but according to some implementations of the present disclosure, the first semiconductor chip C1 and the second semiconductor chip C2 may have different sizes.

According to some implementations, the second semiconductor chip C2 may include a rear redistribution structure 240 for redistributing second through-vias 230. The rear redistribution structure 240 may redistribute electricity (e.g., signals) from the second through-vias 230 to first through-vias 130 and/or first front pads 104 of the first semiconductor chip C1 even when horizontal/lateral positions of the second through-vias 230 differ from horizontal/lateral positions of the first through-vias 130 and first front pads 104, such that the first semiconductor chip C1 can be designed without restrictions on a TSV region.

For example, the first semiconductor chip C1 may include a first TSV region R1 in which the first through-vias 130 are arranged, and the second semiconductor chip C2 may include a second TSV region R2 in which the second through-vias 230 are arranged. In this case, at least a portion of the first TSV region R1 may be offset from the second TSV region R2 in a horizontal direction (e.g., X-direction). Rear pads 205 of the second semiconductor chip C2 may be formed to be aligned with the first through-vias 130 of the first semiconductor chip C1, and a rear redistribution layer 245 of the rear redistribution structure 240 may electrically connect the second through-vias 230 to the rear pads 205 of the second semiconductor chip C2.

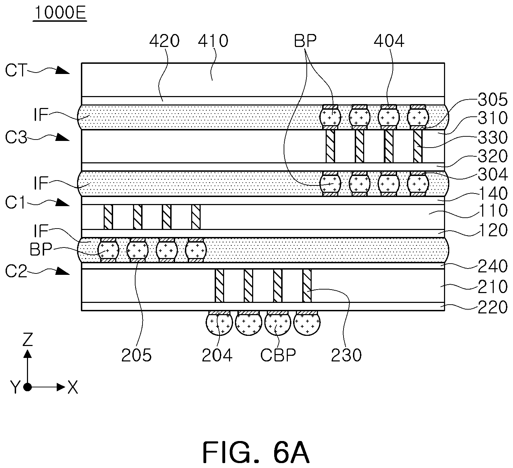

The semiconductor device 1000A may further include an uppermost semiconductor chip CT. According to some implementations of the present disclosure, two or more semiconductor chips may be stacked between the uppermost semiconductor chip CT and the base chip C2 (see the examples of FIGS. 6A to 8B). Although the uppermost semiconductor chip CT is illustrated as not including through-vias, in some implementations, the upper semiconductor chip CT may further include through-vias penetrating through a substrate 410.

The first semiconductor chip C1, the second semiconductor chip C2, and the uppermost semiconductor chip CT may be IC chips with integrated circuits formed. The first semiconductor chip C1 and the second semiconductor chip C2 may be different types of semiconductor chips. The first semiconductor chip C1, the second semiconductor chip C2, and the uppermost semiconductor chip CT may include, for example, logic chips such as a central processor (CPU), a graphics processor (GPU), an image processor (ISP), a field programmable gate array (FPGA), a digital signal processor, an encryption processor, microprocessors, a microcontroller, an analog-to-digital converter, and application-specific IC (ASIC), or memory chips including a volatile memory such as a dynamic RAM (DRAM) and a static RAM (SRAM) and a non-volatile memory such as a phase change RAM (PRAM), a magnetic RAM (MRAM), a resistive RAM (RRAM), and a flash memory.

Hereinafter, the components of each of the first semiconductor chip C1, the second semiconductor chip C2, and the uppermost semiconductor chip CT will be described.

The first semiconductor chip C1 may include a first substrate 110, a first circuit layer 120, and first through-vias 130. Furthermore, the first semiconductor chip C1 may include first front pads 104 and first rear pads 105.

The first substrate 110 may be a semiconductor wafer. The first substrate 110 may include, for example, a semiconductor element such as silicon and germanium, or a compound semiconductor such as silicon carbide (SiC), gallium arsenide (GaAs), indium arsenide (InAs), and indium phosphide (InP). The first substrate 110 may include a conductive region 112 and an isolation region 113 formed on one surface thereof. The conductive region 112 may be, for example, a well doped with impurities or a structure doped with impurities. The isolation region 113 may be a device isolation structure having a shallow trench isolation (STI) structure and may include silicon oxide.

Individual elements ID may be electrically connected to the conductive region 112 of the first substrate 110. The individual elements ID may include, for example, FET such as planar FET or FinFET, memory devices such as a flash memory, DRAM, SRAM, EEPROM, PRAM, MRAM, FeRAM and RRAM, logic devices such as AND, OR and NOT, and various devices and/or passive devices such as system LSI, CIS and MEMS. The individual elements ID may include a gate structure 115. The gate structure 115 may include a gate insulating layer GI, a gate electrode GE disposed on the gate insulating layer GI, and a gate spacer GS surrounding the gate insulating layer GI and the gate electrode GE. The gate insulating layer GI may include silicon oxide or silicon nitride. The gate electrode GE may include a semiconductor material and a metal material. The gate spacer GS may be formed of a silicon oxide film, a silicon nitride film, a silicon carbide film, or combinations thereof.

The first circuit layer 120 may be disposed on one surface of the first substrate 110 on which the conductive region 112 is formed. The first circuit layer 120 may include an interlayer insulating layer 121 and a wiring structure 125. The interlayer insulating layer 121 may be formed to cover the individual elements ID and the wiring structure 125, and may electrically separate the individual elements ID disposed on the first substrate 110. The interlayer insulating layer 121 may be formed of Flowable Oxide (FOX), Tonen SilaZen (TOSZ), Undoped Silica Glass (USG), Borosilica Glass (BSG), PhosphoSilaca Glass (PSG), BoroPhosphoSilica Glass (BPSG), Plasma Enhanced Tetra Ethyl (PETEOS). Fluoride Silicate Glass (FSG), High Density Plasma (HDP) oxide, Plasma Enhanced Oxide (PEOX), Flowable CVD (FCVD) oxide, or combinations thereof. At least a portion of the interlayer insulating layer 121 surrounding the wiring structure 125 may be formed of a low dielectric layer. The interlayer insulating layer 121 may be formed using a chemical vapor deposition (CVD) process, a flowable CVD process, or a spin coating process.

The wiring structure 125 may formed in a multilayer structure including a plurality of wiring patterns and a plurality of vias, which are formed of, for example, aluminum (Al), gold (Au), cobalt (Co), copper (Cu), nickel (Ni), lead (Pb), tantalum (Ta), tellurium (Te), titanium (Ti), tungsten (W), or combinations thereof. A barrier film including titanium (Ti), titanium nitride (TiN), tantalum (Ta), or tantalum nitride (TaN) may be disposed between the wiring pattern or/and the via and the interlayer insulating layer 121. The wiring structure 125 may be electrically connected to the individual elements ID by an interconnector 123 (e.g., a contact plug).

The first through-vias 130 may penetrate through the first substrate 110 and may be electrically connected to the first front pads 104 and the first rear pads 105. The first through-vias 130 may include at least one of a signal via, a power via, and a ground via electrically connected to the wiring structure 125. The first front pads 104 may be disposed below the first circuit layer 120.

The first through-vias 130 may include a via plug 135 and a side barrier film 131 surrounding a side surface of the via plug 135. The via plug 135 may include, for example, tungsten (W), titanium (Ti), aluminum (Al), or copper (Cu), and may be formed through a plating process, a PVD process, or a CVD process. The side barrier film 131 may include titanium (Ti), titanium nitride (TiN), tantalum (Ta), or tantalum nitride (TaN), and may be formed through a plating process, a PVD process, or a CVD process. A side insulating film including an insulating material (e.g., high aspect ratio process (HARP) oxide) such as silicon oxide, silicon nitride, or silicon oxynitride may be formed between the side barrier film 131 and the first substrate 110. The first front pads 104 and first rear pads 105 may include at least one of aluminum (Al), copper (Cu), nickel (Ni), tungsten (W), platinum (Pt), and gold (Au).

The second semiconductor chip C2 may be disposed below the first semiconductor chip C1. The second semiconductor chip C2 may be arranged in a direction in which the second rear pads 205 face the first front pads 104. The second semiconductor chip C2 may include a second substrate 210, a second circuit layer 220, and second through-vias 230. Since the second substrate 210, the second circuit layer 220, and the second through-vias 230 have features identical or similar to those of the first substrate 110, the first circuit layer 120, and the first through-vias 130 as described above, overlapping descriptions thereof are omitted.

The second semiconductor chip C2 may include a rear redistribution structure 240 for redistributing the second through-vias 230 and connecting the second through-vias 230 to the first through-vias 130 of the first semiconductor chip C1. The rear redistribution structure 240 may include a dielectric layer 241 and a rear redistribution layer 245. The dielectric layer 241 may include silicon oxide, silicon nitride, or combinations thereof. The dielectric layer 241 may be formed using a chemical vapor deposition (CVD) process, a flowable-CVD process, or a spin coating process.

The rear redistribution layer 245 may be formed in a multilayer structure including a plurality of wiring patterns and a plurality of vias, which are formed of, for example, aluminum (Al), gold (Au), cobalt (Co), copper (Cu), nickel (Ni), lead (Pb), tantalum (Ta), tellurium (Te), titanium (Ti), tungsten (W), or combinations thereof. A barrier film including titanium (Ti), titanium nitride (TiN), tantalum (Ta), or tantalum nitride (TaN) may be disposed between the rear redistribution layer 245 and the dielectric layer 241. The rear redistribution layer 245 may extend in the horizontal direction and electrically connect the second through-vias 230 and the second rear pads 205.

The second rear pads 205 may be aligned with the first through-vias 130 or the first front pads 104 in a vertical direction. For example, at least one 205' of the second rear pads 205 may be spaced apart from a corresponding one 230' of the second through-vias 230 in the horizontal direction (e.g., X-direction), and may overlap (at least partially extend over/under) a corresponding one 130' of the through-vias 130 in a vertical direction (e.g., Z-direction). One 104' of the first front pads 104 may overlap (at least partially extend over/under) a corresponding one 130' of the first through-vias 130 in the vertical direction (Z-direction). One 104' of the first front pads 104 may be aligned with a corresponding one 205' of the second rear pads 205 in the vertical direction (Z-direction). One 130' of the first through-vias 130 and one 230' of the second through-vias 230 that correspond to each other may not overlap each other in the vertical direction (Z-direction).

The second semiconductor chip C2 may be a lowermost semiconductor chip among the stacked chips. A plurality of connection bumps CBP may be disposed below the second semiconductor chip C2. The plurality of connection bumps CBP may be electrically connected to the second front pads 204. The plurality of connection bumps CBP may include tin (Sn), indium (In), bismuth (Bi), antimony (Sb), copper (Cu), silver (Ag), zinc (Zn), lead (Pb), and/or alloys thereof. According to some implementations of the present disclosure, the plurality of connection bumps CBP may have a combination of metal pillars and solder balls.

The uppermost semiconductor chip CT may be disposed on the first semiconductor chip C1. The uppermost semiconductor chip CT may be disposed on an uppermost portion of the stacked chips. The uppermost semiconductor chip CT may include a semiconductor substrate 410 and an integrated circuit layer 420. Front pads 404 may be disposed below the integrated circuit layer 420. Since the semiconductor substrate 410 and the integrated circuit layer 420 have the features identical to or similar to the first substrate 110 and the first circuit layer 120 as described above, overlapping descriptions thereof will be omitted. The uppermost semiconductor chip CT may not include through-vias. In this case, an upper surface of the semiconductor substrate 410 may be covered with an insulating film formed of a silicon oxide film, a silicon nitride film, a polymer, or combinations thereof. According to some implementations of the present disclosure, the uppermost semiconductor chip CT may further include through-vias penetrating through the semiconductor substrate 410. For example, the uppermost semiconductor chip CT may include a pixel array and through-vias connected to the pixel array through a plurality of row lines and a plurality of column lines.

Furthermore, the semiconductor device 1000A further includes bumps BP and an insulating film layer IF, which are disposed between the first semiconductor chip C1, the second semiconductor chip C2, and the uppermost semiconductor chip CT. The bumps BP may be disposed between the front pads 104 and 404 and the rear pads 105 and 205. The bumps BP may electrically connect the first through-vias 130 and the second through-vias 230.

The bumps BP may include tin (Sn), indium (In), bismuth (Bi), antimony (Sb), copper (Cu), silver (Ag), zinc (Zn), lead (Pb) and/or alloys thereof, and according to some implementations, the bumps BP may have a form in which metal pillars and solder balls are combined. The insulating film layer IF may surround the bumps BP and fix the semiconductor chips C1, C2 and CT. The insulating film layer IF may be a non-conductive film (NCF), but the present disclosure is not limited thereto, for example, the insulating film layer IF may be formed of all kinds of insulating film capable of a thermal compression process.

As illustrated in FIG. 1C, the first semiconductor chip C1 may include a first IC region IC1 and a first TSV region R1. The second semiconductor chip C2 may include a second IC region IC2 and a second TSV region R2.

Cells or circuits constituting the above-described logic chip or memory chip may be formed in the first and second IC regions IC1 and IC2. In the first TSV region R1, the first through-vias 130 may be disposed adjacent to each other vertically and horizontally. In the second TSV region R2, the second through-vias 230 may be arranged adjacent to each other vertically and horizontally.

In some implementations, the first TSV region R1 may include two or more sub-TSV regions R1a and R1b spaced apart from each other. The first TSV region R1 may include a first sub-TSV region R1a and a second sub-TSV region R1b, each of which extends in one direction (e.g., Y-direction). On a plane, the first sub-TSV region R1a may be adjacent to a first side of the first semiconductor chip C1, and the second sub-TSV region R1b may be adjacent to a second side of the first semiconductor chip C1. The first IC region IC1 may be disposed between the first sub-TSV region R1a and the second sub-TSV region R1b.

The first through-vias 130 may include first sub-vias 130a arranged in the first sub-TSV region R1a and second sub-vias 130b arranged in the second sub-TSV region R1b. A separation distance D between the first sub-TSV region R1a and the second sub-TSV region R1b may be greater than a distance d1 between the first sub-vias 130a adjacent to each other and a distance d2 between the second sub-vias 130b adjacent to each other.

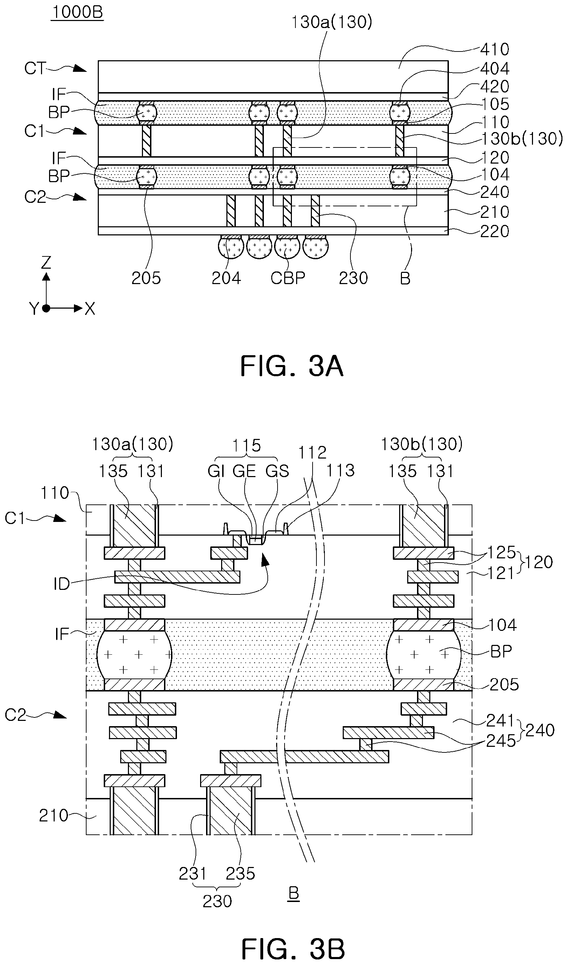

However, the shape of the first and second TSV regions R1 and R2 may be changed into various shapes different from those illustrated in FIG. 1C depending on the design of the first semiconductor chip C1 and the second semiconductor chip C2. For example, either the first sub-TSV region R1a or the second sub-TSV region R1b may overlap the second TSV region R2 (see FIGS. 3A and 3B).

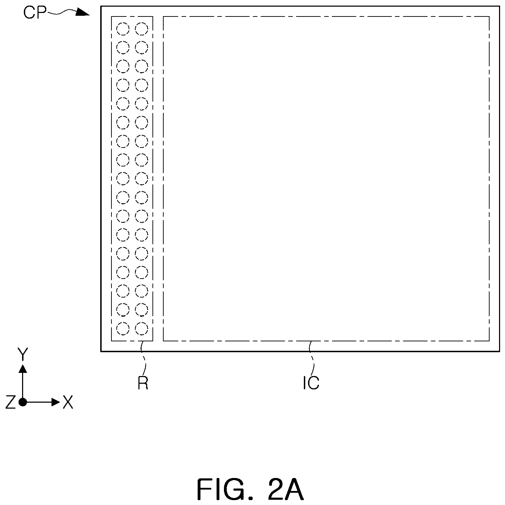

Hereinafter, modified examples of the TSV region R applicable to the semiconductor chips C1, C2, and CT will be described with reference to FIGS. 2A to 2D.

FIGS. 2A to 2D are plane views of modified examples of a TSV region R.

Referring to FIG. 2A, in a modified example, a TSV region R may be disposed in only one side of an IC region IC. The TSV region R may extend along a side surface of the semiconductor chip CP in a first direction (e.g., Y-direction).

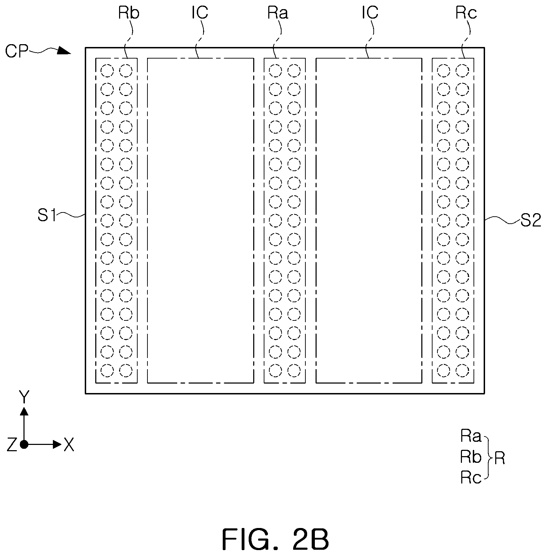

Referring to FIG. 2B, in a modified example, the TSV region R may be disposed in both sides of the IC region IC. The TSV region R may include sub-TSV regions Ra, Rb and Rc spaced apart from each other. The first sub-TSV region Ra may extend from a central portion of the semiconductor chip CP in a first direction (e.g., Y-direction). The second sub-TSV region Rb may be spaced apart from the first sub-TSV region Ra in a second direction (e.g., X-direction) and may be disposed adjacent to a first edge S1 of the semiconductor chip CP. The third sub-TSV region Rc may be spaced apart from the first sub-TSV region Ra in the second direction (e.g., X-direction) and disposed adjacent to a second edge S2 of the semiconductor chip CP. The third sub-TSV region Rc may be disposed opposite to the second sub-TSV region Rb.

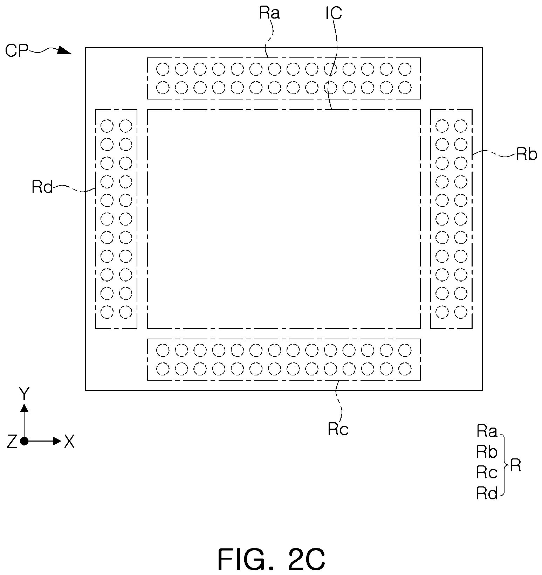

Referring to FIG. 2C, in a modified example, the TSV region R may be disposed to surround the IC region IC. The TSV region R may include sub-TSV regions Ra, Rb, Rc and Rd adjacent to edges of the semiconductor chip CP. For example, the TSV region R includes a first sub-TSV region Ra, a second sub-TSV region Rb, a third sub-TSV region Rc, and a third sub-TSV region Rc, which are disposed adjacent to four surfaces of the IC region IC, respectively.

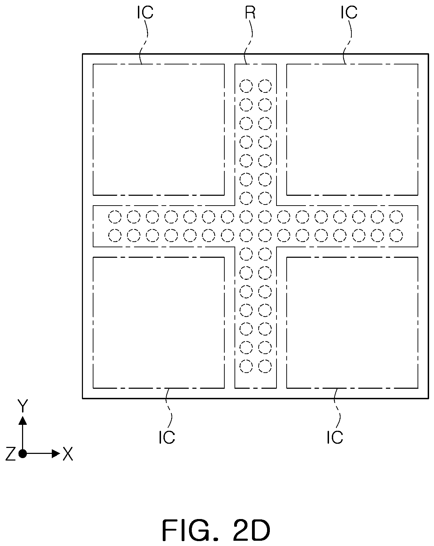

Referring to FIG. 2D, in a modified example, the TSV region R may be disposed between the IC regions IC. The TSV region R may extend from the central portion of the semiconductor chip CP in the first direction (e.g., Y-direction) and the second direction (e.g., X-direction).

As described above, the first TSV region R1 and the second TSV region R2 illustrated in FIG. 1C may be defined in various shapes and are not limited to the shapes illustrated in FIGS. 1C and 2A to 2D.

FIG. 3A is a cross-sectional view of a semiconductor device 1000B according to some implementations of the present disclosure, and FIG. 3B is a partial enlarged view of region 'B' of FIG. 3A.

Referring to FIGS. 3A and 3B, a semiconductor device 1000B of some implementations may have the features identical or similar to those described with reference to FIGS. 1A to 2D, except that the semiconductor device 1000B includes first sub-vias 130a and second sub-vias 130b.

According to some implementations, first through-vias 130 may be arranged regardless of an arrangement of second through-vias 230 disposed below the first through-vias 130. For example, the first through-vias 130 may include first sub-vias 130a and second sub-vias 130b. The first sub-vias 130a may overlap (be at least partially aligned with) with the second through-vias 230 in the vertical direction (Z-direction). The second sub-vias 130b may not overlap the second through-vias 230 in the vertical direction (Z-direction). At least some of the second through-vias 230 may be electrically redistributed to the second sub-vias 130b through the rear redistribution layer 245.

In this manner, the second through-vias 230 may be redistributed by the rear redistribution structure 240 of the second semiconductor chip C2, thereby designing the semiconductor device 1000B.

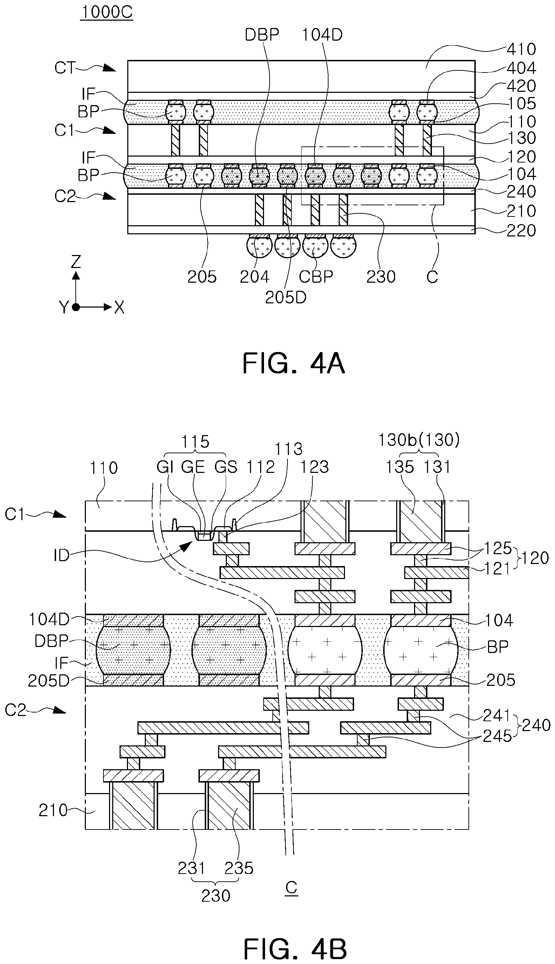

FIG. 4A is a cross-sectional view of a semiconductor device 1000C according to some implementations of the present disclosure, and FIG. 4B is a partial enlarged view of region 'C' of FIG. 4A.

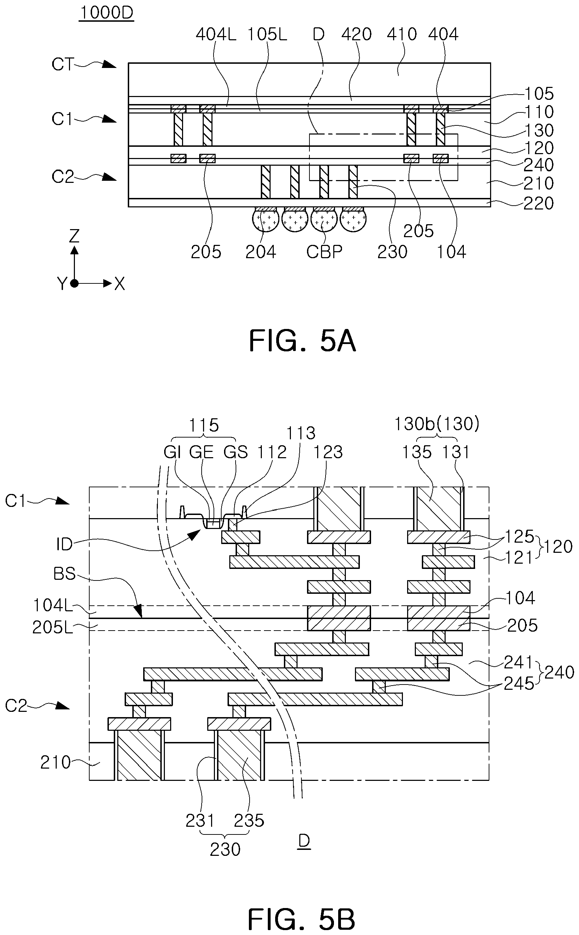

Referring to FIGS. 4A and 4B, a semiconductor device 1000C of some implementations may have features identical or similar to those described with reference to FIGS. 1A to 3B, except that the semiconductor device 1000C includes dummy structures 104D, 205D and DBP. The first semiconductor chip C1 may include first dummy pads 104D adjacent to first front pads 104. The second semiconductor chip C2 may include second dummy pads 205D adjacent to second rear pads 205. The first dummy pads 104D and the second dummy pads 205D may be connected by dummy bumps DBP. According to some implementations, the first dummy pads 104D and the second dummy pads 205D may be in contact with each other without bumps (see the example of FIGS. 5A and 5B). The first dummy pads 104D and the second dummy pads 205D may be electrically insulated from the first through-vias 130 and the second through-vias 230. According to some implementations, the first semiconductor chip C1 and/or the second semiconductor chip C2 may further include dummy through-vias connected to the first dummy pads 104D and the second dummy pads 205D.

FIG. 5A is a cross-sectional view of a semiconductor device 1000D according to some implementations of the present disclosure, and FIG. 5B is a partial enlarged view of region 'D' of FIG. 5A.

Referring to FIGS. 5A and 5B, a semiconductor device 1000D of some implementations may have features identical or similar to those described with reference to FIGS. 1 to 4B, except that a plurality of semiconductor chips C1, C2 and CT are directly connected and coupled to each other without separate connecting members (e.g., metal pillars, solder bumps, adhesive films, etc.) (a configuration which may be referred to, for example, as hybrid bonding and direct bonding).

A first semiconductor chip C1 may include a front insulating layer 104L surrounding first front pads 104 and a rear insulating layer 105L surrounding rear pads 105. The second semiconductor chip C2 may include a rear insulating layer 205L surrounding rear pads 205. An uppermost semiconductor chip CT may include a front insulating layer 404L surrounding front pads 404. The front insulating layers 104L and 404L and the rear insulating layers 105L and 205L may be referred to as a first insulating layer, a second insulating layer, a third insulating layer, etc., respectively.

The front insulating layers 104L and 404L and the rear insulating layers 105L and 205L may include at least one of a material that may be bonded and coupled to each other, for example, silicon oxide (SiO) and silicon carbonitride (SiCN). The front pads 104 and 404 and the rear pads 105 and 205 adjacent to each other may include a material that may be bonded and coupled to each other, for example, one of copper (Cu), nickel (Ni), gold (Au) and silver (Ag), or alloys thereof. A bonding surface BS formed by means of metal bonding by the front pads 104 and 404 and the rear pads 105 and 205, and dielectric bonding by the front insulating layers 104L and 404L and the rear insulating layers 105L and 205L may be formed between the plurality of semiconductor chips C1, C2 and CT.

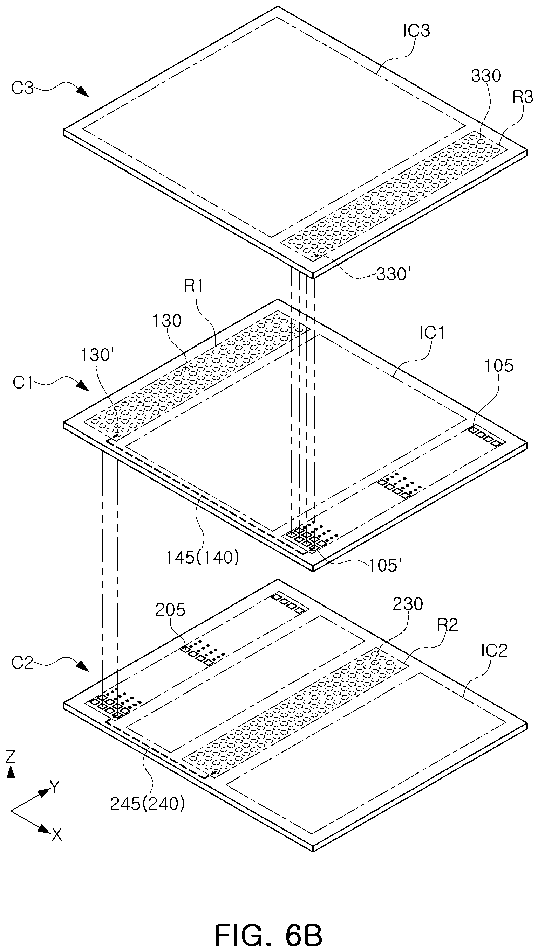

FIG. 6A is a cross-sectional view of a semiconductor device 1000E according to some implementations of the present disclosure, and FIG. 6B is a perspective view illustrating a connection relationship of some semiconductor chips of FIG. 6A.

Referring to FIGS. 6A and 6B, a semiconductor device 1000E of some implementations may have features identical to or similar to those described with reference to FIGS. 1A to 5B, except that the semiconductor device 1000E further includes a third semiconductor chip C3 between a first semiconductor chip C1 and an uppermost semiconductor chip CT.

The third semiconductor chip C3 may include a third substrate 310, a third circuit layer 320, and third through-vias 330. Furthermore, the third semiconductor chip C3 may include third front pads 304 and third rear pads 305. Since sub-elements of the third semiconductor chip C3 have the features identical or similar to the sub-elements of the first semiconductor chip C1 described above, overlapping descriptions thereof will be omitted.

The first semiconductor chip C1 may include a rear redistribution structure 140 for redistributing first through-vias 130 and connecting the first through-vias 130 to the third through-vias 330 of the third semiconductor chip C3. The rear redistribution structure 140 may have the features identical or similar to the rear redistribution structure 240 of the second semiconductor chip C2 described above.

The first rear pads 105 may be aligned with the third through-vias 330 or the third front pads 304 in the vertical direction. For example, at least one 105' of the first rear pads 105 may be spaced apart from a corresponding one 130' of the first through-vias 130 in the horizontal direction (e.g., X-direction), and may overlap with a corresponding one 330' of the third through-vias 330 in the vertical direction (e.g., Z-direction). One 130' of the first through-vias 130 and one 330' of the third through-vias 330 corresponding to each other may not overlap each other in the vertical direction (Z-direction).

As illustrated in FIG. 6B, the first semiconductor chip C1 may include a first IC region IC1 and a first TSV region R1. The second semiconductor chip C2 may include a second IC region IC2 and a second TSV region R2. The third semiconductor chip C3 may include a third IC region IC3 and a third TSV region R3.

Cells or circuits constituting the above-described logic chip or memory chip may be formed in first to third IC regions IC1, IC2 and IC3. In the first TSV region R1, first through-vias 130 may be disposed adjacent to each other vertically and horizontally. In the second TSV region R2, second through-vias 230 may be disposed adjacent to each other vertically and horizontally. In the third TSV region R3, third through-vias 330 may be disposed adjacent to each other vertically and horizontally.

In some implementations, the first to third TSV regions R1, R2 and R3 may be offset in the horizontal direction (e.g., X-direction). An offset distance of the first to third TSV regions R1, R2 and R3 may be greater than a gap between the first through-vias 130 adjacent to each other, a gap between the second through-vias 230 adjacent to each other, and a gap between the third through-vias 330.

However, the shape of the first to third TSV regions R1, R2 and R3 may be changed into various shapes different from those illustrated in FIG. 6B depending on the design of the first to third IC regions IC1, IC2 and IC3.

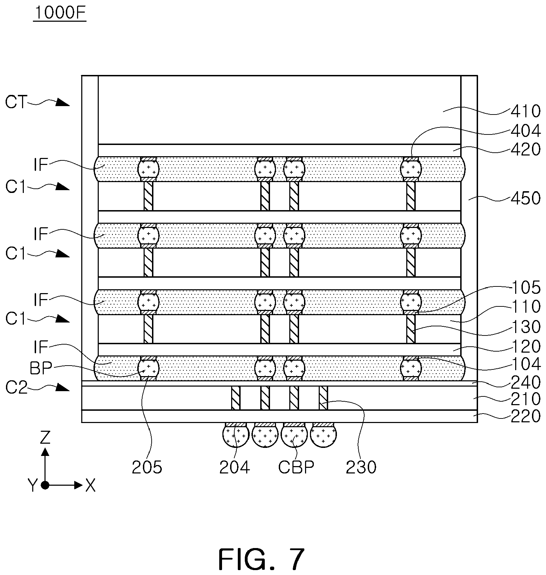

FIG. 7 is a cross-sectional view of a semiconductor device 1000F according to some implementations of the present disclosure.

Referring to FIG. 7, a semiconductor device 1000F of some implementations may have the features identical or similar to those described with reference to FIGS. 1A to 6B, except that the semiconductor device 1000F includes a plurality of first semiconductor chips C1 and a sealing layer 450.

A plurality of first semiconductor chips C1 may be sequentially stacked on the second semiconductor chip C2. The second semiconductor chip C2 may be a buffer chip including a plurality of logic elements and/or memory elements in a circuit layer 220. Accordingly, the second semiconductor chip C2 may transmit signals from the first semiconductor chips C1 and an uppermost semiconductor chip CT stacked on an upper portion to the outside, and may also transmit signals and power from the outside to the first semiconductor chips C1 and the uppermost semiconductor chip CT. The second semiconductor chip C2 may perform both a logic function and a memory function through logic elements and memory elements, but according to some implementations, only the logic function may be performed by including only the logic elements. The second semiconductor chip C2 may have a width greater than that of the first semiconductor chips C1 and the uppermost semiconductor chip CT.

A plurality of first semiconductor chips C1 and the uppermost semiconductor chip CT may be the same type of IC chip. The plurality of first semiconductor chips C1 may all have the same arrangement of first through-vias 130. The first through-vias 130 of each of the plurality of first semiconductor chips C1 may be aligned with the corresponding through-vias in the vertical direction (Z-direction). The plurality of first semiconductor chips C1 and the uppermost semiconductor chip CT may be comprised of memory chips or memory elements for storing or outputting data based on address commands and control commands received from the second semiconductor chip C2. For example, the plurality of first semiconductor chips C1 and the uppermost semiconductor chip CT may include volatile memory elements such as DRAM or SRAM, or non-volatile memory elements such as a flash memory, PRAM, MRAM, FeRAM, or RRAM.

The uppermost semiconductor chip CT does not include through-vias, and an upper surface thereof may be exposed from the sealing layer 450, but the present disclosure is not limited thereto. For example, the sealing layer 450 may be formed of an insulating material such as an epoxy mold compound (EMC), but the present disclosure is not particularly limited thereto.

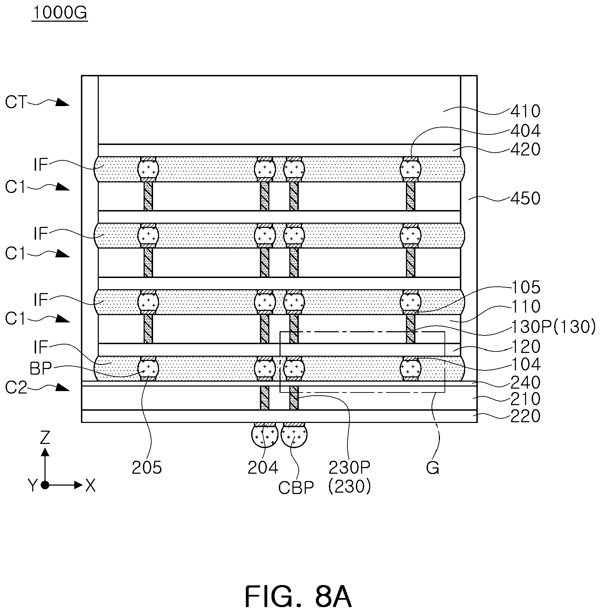

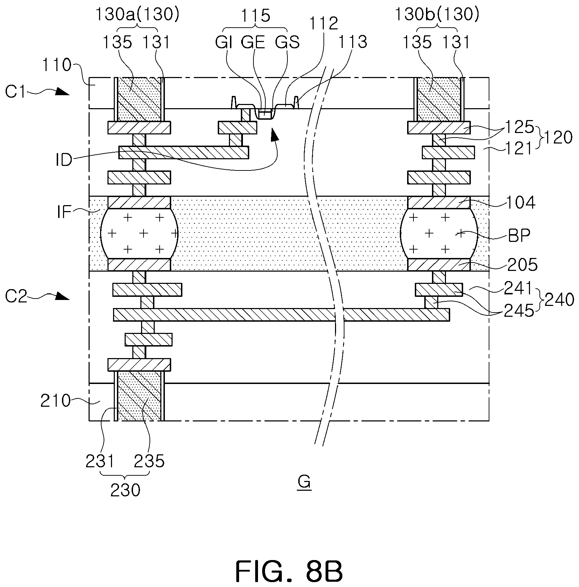

FIG. 8A is a cross-sectional view of a semiconductor device 1000G according to some implementations of the present disclosure, and FIG. 8B is a partial enlarged view of region `E' of FIG. 8A.

Referring to FIGS. 8A and 8B, a semiconductor device 1000G of some implementations may have the features identical to or similar to those described with reference to FIGS. 1A to 7, except for an arrangement of power supply vias 130P and 230P. The first through-vias 130 and the second through-vias 230 may include at least one of a power via and a ground via. Hereinafter, a `power supply via' may be referred to as a `power via,' which may denote at least one of a power via and a ground via.

In some implementations, the first through-vias 130 may include first power vias 130P, and the second through-vias 230 may include second power vias 230P. The first power vias 130P and the second power vias 230P may be electrically connected by a rear redistribution layer 245. The first power vias 130P may include first sub-vias 130a and second sub-vias 130b. The first sub-vias 130a may overlap (be at least partially aligned with) the second power vias 230P in a vertical direction. The second sub-vias 130b may not overlap the second power vias 230P. The second through-vias 230 may be electrically connected to the first sub-vias 130a and the second sub-vias 130b through the rear redistribution layer 245. The second rear pads 205 may be aligned with the first sub-vias 130a and the second sub-vias 130b in the vertical direction.

The first semiconductor chip C1 of some implementations may include a first power supply region in which first sub-vias 130a (which may be referred to as 'first power supply vias') are disposed, and a second power supply region in which second sub-vias 130b (which may be referred to as 'second power supply vias') are disposed. Here, the first power supply region and the second power supply region may be understood as being disposed similarly to the sub-TSV regions Ra, Rb and Rc illustrated in FIG. 2B.

The number of first through-vias 130 may be greater than the number of second through-vias 230. The rear redistribution layer 245 may connect one of the second through-vias 230 and at least two of the rear pads 205. For example, one of the second power vias 230P may be electrically connected to both a corresponding one of the first sub-vias 130a and a corresponding one of the second sub-vias 130b by the rear redistribution layer 245. The number of first sub-vias 130a may be identical to the number of second power vias 230P, but the present disclosure is not limited thereto.

In this manner, the second power vias 230P and the added second sub-vias 130b may be connected through the rear redistribution layer 245, thereby improving the power delivery characteristics of the semiconductor device 1000G.

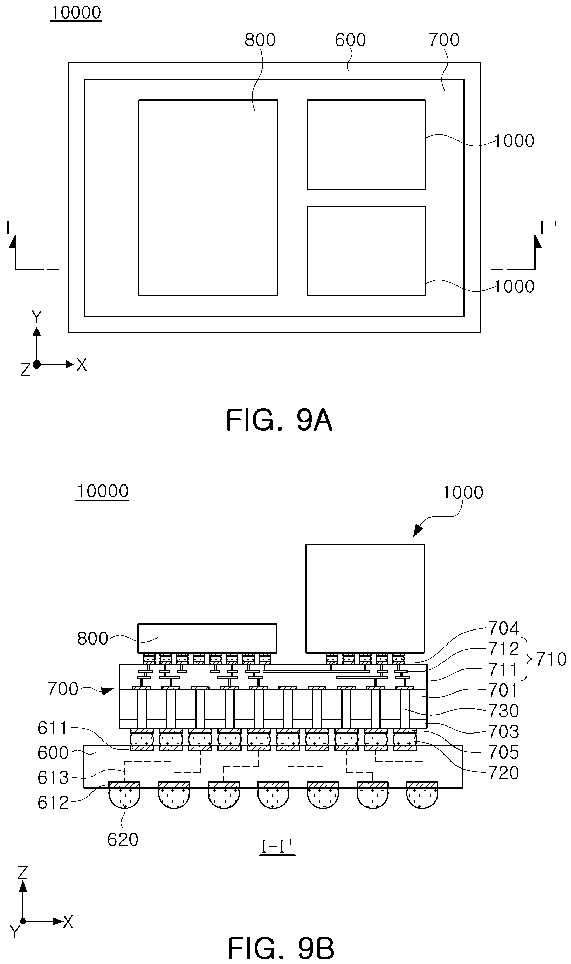

FIG. 9A is a plan view of an example of a semiconductor package 10000 on which a semiconductor device 1000 according to some implementations of the present disclosure is mounted, and FIG. 9B is a cross-sectional view taken along line I-I' of FIG. 9A.

Referring to FIGS. 9A and 9B, a semiconductor package 10000 may include a package substrate 600, an interposer substrate 700, at least one semiconductor device 1000, and a processor unit 800. The semiconductor device 1000 may have the features identical to or similar to the semiconductor devices 1000A, 1000B, 1000C, 1000D, 1000E, 1000F and 1000G described with reference to FIGS. 1A to 8B. According to some implementations, the semiconductor device 1000 may be mounted alone on the interposer substrate 700 or the package substrate 600.

The package substrate 600 is a support substrate on which the interposer substrate 700, the processor unit 800, and the semiconductor device 1000 are mounted, and may be a board for a semiconductor package including a printed circuit board (PCB), a ceramic board, a glass board and a tape wiring board. A body of the package substrate 600 may include different materials depending on the type of substrates. For example, if the package substrate 600 is a printed circuit board, the package substrate 600 may have a form in which a wiring layer is additionally stacked on a cross-sectional surface or both surfaces of a body copper foil laminate or a copper foil laminate.

The package substrate 600 may include a lower terminal 612, an upper terminal 611, and a redistribution circuit 613. The upper terminal 611, the lower terminal 612, and the redistribution circuit 613 may form an electrical path for connecting a lower surface and an upper surface of the package substrate 600. The upper terminal 611, the lower terminal 612, and the redistribution circuit 613 are metal materials, for example, at least one metal or two or more metals of copper (Cu), aluminum (Al), nickel (Ni), silver (Ag), gold (Au), platinum (Pt), tin (Sn), lead (Pb), titanium (Ti), chromium (Cr), palladium (Pd), indium (In), zinc (Zn), and carbon (C). An external connection terminal 620 connected to the lower terminal 612 may be disposed on the lower surface of the package substrate 600. The external connection terminal 620 may include tin (Sn), indium (In), bismuth (Bi), antimony (Sb), copper (Cu), silver (Ag), zinc (Zn), lead (Pb) and/or alloys thereof.

The interposer substrate 700 may include a substrate 701, a lower protective layer 703, lower pads 705, an interconnection structure 710, a metal bump 720, and a through-via 730. The semiconductor device 1000 and the processor unit 800 may be electrically connected to each other via the interposer substrate 700.

The substrate 701 may be formed of, for example, any one of silicon, organic, plastic, and a glass substrate. When the substrate 701 is a silicon substrate, the interposer substrate 700 may be referred to as a silicon interposer. When the substrate 701 is an organic substrate, the interposer substrate 700 may be referred to as a panel interposer.

The lower protective layer 703 may be disposed on a lower surface of the substrate 701, and the lower pads 705 may be disposed below the lower protective layer 703. The lower pads 705 may be connected to the through-via 730. The semiconductor device 1000 and the processor unit 800 may be electrically connected to the package substrate 600 through the metal bumps 720 disposed below the lower pads 705.

The interconnection structure 710 may be disposed on an upper surface of the substrate 701 and may include an interlayer insulating layer 711 and a single-layer or multilayer wiring structure 712. When the interconnection structure 710 has a multi-layer wiring structure, wiring patterns of different layers may be connected to each other through contact vias.

The through-via 730 may extend from the upper surface to the lower surface of the substrate 701 and may penetrate through the substrate 701. Furthermore, the through-via 730 may extend into an interior of the interconnection structure 710 and may be electrically connected to wirings of the interconnection structure 710. When the substrate 701 is silicon, the through-via 730 may be referred to as a TSV. According to some implementations, the interposer substrate 700 may include only interconnection structures therein and may not include through-vias.

The interposer substrate 700 may be used to convert or transmit an input electrical signal between the package substrate 600 and the semiconductor device 1000 or the processor unit 800. Accordingly, the interposer substrate 700 may not include devices such as active devices or passive devices. Furthermore, according to some implementations, the interconnection structure 710 may be disposed below the through-via 730. For example, a positional relationship between the interconnection structure 710 and the through-via 730 may be considered relative.

The metal bump 720 may electrically connect the interposer substrate 700 and the package substrate 600. The semiconductor device 1000 may be electrically connected to the metal bump 720 through the wirings of the interconnection structure 710 and the through-via 730. According to some implementations, the lower pads 705 used for power or a ground may be integrated and connected together to the metal bump 720, so that the number of lower pads 705 may be greater than the number of metal bumps 720.

The processor unit 800 may include, for example, a central processor (CPU), a graphics processor (GPU), a field programmable gate array (FPGA), a digital signal processor (DSP), an encryption processor, microprocessors, microcontrollers, an analog-to-digital converter, and an application-specific integrated circuit (ASIC).

According to some implementations, the semiconductor package 10000 may further include an internal sealant for covering the semiconductor device 1000 and the processor unit 800 on the interposer substrate 700. Furthermore, the semiconductor package 10000 may further include an external sealant for covering the interposer substrate 700 and the internal sealant on the package substrate 600. The external sealant and the internal sealant may be formed together and may not be distinguished and recognized. According to some implementations, the semiconductor package 10000 may further include a heat dissipation structure for covering the semiconductor device 1000 and the processor unit 800.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

The scope of the present disclosure is not limited to the above-described examples and the accompanying drawings. Therefore, those of ordinary skill in the art may make various replacements, modifications, or changes without departing from the scope of the present disclosure defined by the appended claims, and these replacements, modifications, or changes should be construed as being included in the scope of the present disclosure.

## Claims

1. A semiconductor device comprising:
a first semiconductor chip (C1) including first through-vias (130) and first front pads (104) electrically connected to the first through-vias (130); and
a second semiconductor chip (C2) disposed below the first semiconductor chip (C1), the second semiconductor chip (C2) including
a substrate (210),
a circuit layer (220) disposed below the substrate (210),
second front pads (204) below the circuit layer (220),
rear pads (205) disposed on the substrate (210) and electrically connected to the first front pads (104),
second through-vias (230) penetrating through the substrate (210) and electrically connected to the second front pads (204), and
a rear redistribution layer (240) electrically connecting the second through-vias (230) to the rear pads (205),
wherein at least one of the rear pads (205) is spaced apart from a corresponding one of the second through-vias (230) in a horizontal direction, and at least partially extends under a corresponding one of the first through-vias (130) in a vertical direction (Z).

2. The semiconductor device of claim 1, wherein one of the first front pads (104) at least partially extends under a second corresponding one of the first through-vias (130) in the vertical direction (Z).

3. The semiconductor device of claim 1 or 2, wherein one of the first front pads (104) at least partially extends over a corresponding one of the rear pads (205) in the vertical direction.

4. The semiconductor device of any one of claims 1 to 3, wherein the first through-vias (130) and the second through-vias (230) are spaced apart from one another in the horizontal direction.

5. The semiconductor device of any one of claims 1 to 4, wherein the first through-vias (130) and the second through-vias (230) each include at least one of a power via or a ground via.

6. The semiconductor device of claim 5, wherein a number of the first through-vias (130) is greater than a number of the second through-vias (230).

7. The semiconductor device of claim 5 or 6, wherein the rear redistribution layer (240) electrically connects one of the second through-vias (230) to at least two of the rear pads (205).

8. The semiconductor device of any one of claims 1 to 7, further comprising:
bumps (BP) that electrically connect the first front pads (104) to the rear pads (205).

9. The semiconductor device of claim 8, wherein the bumps (BP) include tin or a tin alloy.

10. The semiconductor device of any one of claims 1 to 9, wherein the first semiconductor chip (C1) further includes a first insulating layer (104L) surrounding the first front pads (104), and
wherein the second semiconductor chip (C2) further includes a second insulating layer (205L) surrounding the rear pads (205) and in contact with the first insulating layer (104L).

11. The semiconductor device of claim 10, wherein the first front pads (104) and the rear pads (205) are in contact with each other.

12. The semiconductor device of claim 10, wherein the first and second insulating layers (104L, 205L) include at least one of silicon oxide, SiO, silicon nitride ,SiN, or silicon carbonitride, SiCN, and
the first front pads (104) and the rear pads (205) include at least one of copper, Cu, nickel, Ni, gold, Au, silver, Ag, or an alloy thereof.

13. The semiconductor device of any one of claims 1 to 12, wherein the circuit layer (220) includes:
individual circuit elements, and
a wiring structure electrically connecting the individual circuit elements to the second front pads (204) and the second through-vias (230).

14. The semiconductor device of any one of claims 1 to 13, wherein the first semiconductor chip (C1) further includes first rear pads (105) disposed opposite the first front pads (104), and a first rear redistribution layer (140) electrically connecting the first rear pads (105) to the first through-vias (130), and
wherein the semiconductor device further comprises:
a third semiconductor chip (C3) disposed on the first semiconductor chip (C1), the third semiconductor chip (C3) including:
third front pads (404) electrically connected to the first rear pads (105), and
third through-vias (330) electrically connected to the third front pads (304).

15. The semiconductor device of claim 14, wherein at least one of the first rear pads (105) is spaced apart from a second corresponding one of the first through-vias (130) in the horizontal direction, and at least partially extends under a corresponding one of the third through-vias (330) in the vertical direction (Z).
